# EUROPÄISCHE PATENTANMELDUNG

(11) **EP 3 633 262 A1**
(43) Veröffentlichungstag der Anmeldung: **08.04.2020**
(21) Anmeldenummer: 18198569.8
(22) Anmeldetag: 04.10.2018
(51) Int. Cl.: F21S 41/143, F21S 41/255, F21S 41/265, F21S 41/43

(54) **PROJEKTIONSEINRICHTUNG FÜR EIN KRAFTFAHRZEUGSCHEINWERFERLICHTMODUL UND VERFAHREN ZUM HERSTELLEN EINER PROJEKTIONSEINRICHTUNG**

(71) Anmelder: ZKW Group GmbH, 3250 Wieselburg (AT)
(72) Erfinder: Gürtl, Josef, 3233 Kilb (AT); Hacker, Alexander, 3150 Wilhelmsburg (AT)
(74) Vertreter: Patentanwaltskanzlei Matschnig & Forsthuber OG

(57) **Zusammenfassung**

Projektionseinrichtung (1, 100) für ein Kraftfahrzeugscheinwerferlichtmodul umfassend
- zumindest eine Substratschicht (2, 2a, 2b, 2c);
- zumindest ein aus einer Mehrzahl von Mikrooptiken (30, 30a, 30b) und aus einem transparenten Silikon (5) bestehendes Mikrooptik-Array (3, 3a, 3b), welches an einer ersten Fläche (20, 20a, 20b, 20c) der zumindest einen Substratschicht (2, 2a, 2b, 2c) ausgebildet ist und haftet, und
- zumindest ein aus einer Mehrzahl von Mikro-Blenden (40, 40a, 40b) bestehendes Mikro-Blenden-Array (4, 4a, 4b), welches an einer zweiten Fläche (21, 21a, 21b, 21c) der zumindest einen Substratschicht (2, 2a, 2b, 2c) derart angeordnet ist, dass jeder Mikro-Blende (40, 40a, 40b) zumindest eine Mikrooptik (30, 30a, 30b) zugeordnet ist, wobei die zumindest eine Substratschicht (2, 2a, 2b, 2c) transparent und formstabiler als das transparente Silikon (5) ist.

## Beschreibung

Die Erfindung betrifft eine Projektionseinrichtung für ein Kraftfahrzeugscheinwerferlichtmodul, welche Projektionseinrichtung zumindest eine Substratschicht, zumindest ein aus einer Mehrzahl von Mikrooptiken bestehendes Mikrooptik-Array und zumindest ein aus einer Mehrzahl von Mikro-Blenden bestehendes Mikro-Blenden-Array umfasst, wobei das zumindest eine Mikrooptik-Array an einer ersten Fläche der zumindest einen Substratschicht ausgebildet beziehungsweise angeordnet ist und an der ersten Fläche der zumindest einen Substratschicht haftet; das zumindest eine Mikro-Blenden-Array an einer zweiten Fläche der zumindest einen Substratschicht derart angeordnet ist, dass jeder Mikro-Blende zumindest eine Mikrooptik zugeordnet ist.

Darüber hinaus betrifft die Erfindung ein Kraftfahrzeugscheinwerferlichtmodul beziehungsweise Kraftfahrzeugscheinwerfer mit zumindest einer solchen Projektionseinrichtung und ein Verfahren zum Herstellen einer solchen Projektionseinrichtung.

Die Projektionseinrichtungen der oben genannten Art sind aus dem Stand der Technik bekannt (siehe beispielsweise AT 514967 B1, WO 2017066817 A1 oder WO 2017066818 A1). Die Mikrooptiken bei solchen Projektionseinrichtungen weisen für gewöhnlich eine plane Seite auf und sind beispielsweise als plankonvexe oder plankonkave Linsen ausgebildet. Das Mikrooptik-Array weist dabei eine durchgehende plane Fläche auf, die durch die planen Seiten der einzelnen Mikrooptiken gebildet ist. Sowohl die Mikro-Blenden als auch die Mikrooptiken sind bei den vorgenannten Projektionseinrichtung in einem matrixartigen Array angeordnet. Wenn eine solche Projektionseinrichtung in ein Kraftfahrzeugscheinwerferlichtmodul eingebaut wird, wird sie derart normalerweise positioniert, dass das matrixartige Array im Wesentlichen senkrecht zur optischen Achse des Kraftfahrzeugscheinwerferlichtmoduls steht. Mithilfe solcher Projektionseinrichtungen werden Lichtverteilungen gebildet, die als Überlagerung einer Mehrzahl Mikro-Lichtverteilungen gebildet werden, wobei jede Mikro-Lichtverteilung durch eine Mikro-Blende und zumindest eine ihr zugeordnete Mikrooptik geformt wird.

Bei herkömmlichen Projektionseinrichtungen werden die Mikrooptik-Arrays aus UV-Polymeren hergestellt. Die UV Polymere sind sehr kostspielig und verfügen außerdem über eine geringe thermische Belastbarkeit. Dies wird meist zu einem großen Nachteil, wenn eine solche Projektionseinrichtung in einem Kraftfahrzeugscheinwerfer eingesetzt wird. Bekannterweise können in Kraftfahrzeugscheinwerfern hohe Temperaturunterschiede entstehen, da Betriebstemperatur von Kraftfahrzeugscheinwerfern viel höher als Temperatur der Umgebungsluft ist. Diese Temperaturunterschiede führen zu Spannungen zwischen der Substratschicht und dem Mikrooptik-Array. Dies kann wiederum zu einem Verzug und zu Formverlusten sowohl der Substratschicht als auch des Mikrooptik-Arrays führen, wodurch letztendlich die Lichtverteilung an Qualität verliert und womöglich den gesetzlichen Anforderungen nicht mehr gerecht wird. Beispiel einer unvorteilhaften Zusammensetzung ist ein metallisches Mikro-Blenden-Array, eine Substratschicht aus Kunststoff und ein Mikrooptik-Array aus einem UV Polymer. Die Verwendung eines metallischen Mikro-Blenden-Arrays bei der Kombination Kunststoff - UV Polymer führt zu einer erhöhten Wärmeabsorption, wenn die Projektionseinrichtung mit Licht bestrahlt wird. Die Substratschicht und das Mikrooptik-Array dehnen sich aus und verlieren ihre ursprüngliche Form. Dabei wird die Zuordnung von Mikro-Blenden zu den Mikrooptiken beeinträchtigt. Eine Positionierung der Mikro-Blenden zu den Mikrooptiken erfolgt vorzugsweise mit einer Genauigkeit von ca. 0,01 mm, insbesondere sogar in dem Mikrometerbereich. Bei der obengenannten Wärmeausdehnung und Formverlusten der Komponenten der Projektionseinrichtung geht diese Genauigkeit sehr rasch verloren. Das optische Alignment der ganzen Projektionseinrichtung ist nicht mehr vorhanden und die erwünschte Lichtverteilung, beispielsweise Abblendlichtverteilung, kann nicht mehr erzeugt werden.

Die Aufgabe der vorliegenden Erfindung besteht darin, die Nachteile des Standes der Technik zu beseitigen.

Die Aufgabe wird durch eine Projektionseinrichtung der oben genannten Art erfindungsgemäß dadurch gelöst, dass das Mikrooptik-Array aus einem transparenten Silikon ist und die zumindest eine Substratschicht transparent ist und formstabiler als das transparente Silikon ist.

Im Zusammenhang mit der vorliegenden Erfindung wird unter dem Begriff "optisch transparentes" beziehungsweise "lichtdurchlässiges Material" ein Material mit einen Transmissionsgrad T größer als 0,88, vorzugsweise größer als 0,999. Dabei betrifft der angegebene Transmissionsgrad vorzugsweise für Licht in einem Wellenlängenbereich zwischen etwa 400 nm und etwa 700 nm (also sichtbares Licht).

Durch Verwendung von transparentem Silikon kann eine höhere Einsatztemperatur und damit eine höhere Lichtdichte erreicht werden. Außerdem erhöht die Verwendung von transparenten Silikon die Robustheit der Projektionseinrichtung. Robust bezieht sich auf die dauerhafte Verbindung zwischen dem Mikrooptik-Array und der Substratschicht beziehungsweise dauerhaftes Haften des zumindest einen Mikrooptik-Arrays an der zumindest einen Substratschicht.

Die Substratschicht soll also erfindungsgemäß aus einem Material sein, das eine gute Lichttransparenz aufweist und formstabil genug ist. Formstabil genug heißt in dem Kontext, dass die Substratschicht das Mikrooptik-Array aus (weichem) Silikon trägt und sowohl während des Ausbildens der Mikrooptik-Array an der ersten Fläche der Substratschicht als auch während des Einsatzes der Projektionseinrichtung in einem Kraftfahrzeugscheinwerfer ihre Form nicht verliert, d.h. gegen Wärme o. Ä. widerstandsfähig in der Form ist.

Vorzugsweise sind die zumindest eine Substratschicht, das zumindest eine Mikrooptik-Array und das zumindest eine Mikro-Blenden-Array in parallel zueinander verlaufenden und senkrecht zu der optischen Achse der Projektionseinrichtung angeordnet. Die optische Achse der Projektionseinrichtung fällt vorzugsweise mit der Hauptabstrahlrichtung des Kraftfahrzeugscheinwerferlichtmoduls, wenn die Projektionseinrichtung in ein solches Modul fachgemäß eingebaut ist.

Es kann mit Vorteil vorgesehen sein, dass das zumindest eine Mikrooptik-Array mittels eines thermischen Abformverfahrens ausgebildet und zum Haften an der ersten Fläche der Substratschicht gebracht ist und/oder das zumindest eine Mikro-Blenden-Array an der zweiten Fläche der zumindest einen Substratschicht aufgebracht und versiegelt, beispielsweise verklebt, ist.

Dadurch wird das zumindest eine hinsichtlich des Mikrooptik-Arrays angeordnete / positionierte Mikro-Blenden-Array mit der zumindest einen Substratschicht dauerhaft verbunden, sodass keine nachträglichen Justage mehr erforderlich ist. Die einzelnen MikroOptik-Systeme (Mikro-Blende, Mikrooptik und Substratschicht dazwischen) weisen typische Abmessungen von ca. 2 mm x 2 mm (Länge und Breite) und eine Tiefe von ca. 6mm - 10 mm auf. Besonders bei solchen kleinen Projektionseinrichtungen (Mikrooptiken und Mikro-Blenden in Millimeter wenn nicht Mikrometer Größe) ist eine Justagegenauigkeit im µm Bereich wünschenswert. Bei miteinander nicht verbundenen Einzelkomponenten ist es schwierig diese zu justieren und verzugsfrei zu fixieren. Durch die oben genannte direkte Anbindung und Versiegelung, beispielsweise Verklebung, ist eine Nachjustage nicht mehr notwendig.

Hinsichtlich der Stabilität und thermischen Beständigkeit kann es besonders vorteilhaft sein, die zumindest eine Substratschicht aus Glas zu verwenden. Eine solche Glassubstratschicht kann beispielsweise eine Dicke von etwa 0,5 mm bis etwa 4 mm, vorzugsweise von etwa 1,1 mm aufweisen. Eine Glassubstratschicht erhöht Stabilität und Festigkeit der Projektionseinrichtung, wodurch beispielsweise automatisierte Herstellungsverfahren möglich werden. Darüber hinaus bietet eine Glassubstratschicht hohe Transparenz und erhöht chemische und thermische Beständigkeit der Projektionseinrichtung.

Bei einer praxisbewährten Ausführungsform ist vorgesehen, dass das transparente Silikon eine Shore-A-Härte von etwa 30 bis etwa 100, insbesondere von etwa 40 bis etwa 90 aufweist, vorzugsweise transparentes Zwei-Komponenten-Silikon ist, welches Zwei-Komponenten-Silikon vorzugsweise eine Shore-A-Härte in den oben genannten Bereichen aufweist. Solche Silikone können unterschiedliche Wärmedehnungskoeffizienten bei Temperaturschwankungen besser kompensieren.

Es kann außerdem mit Vorteil vorgesehen sein, dass die Mikro-Blenden derart ausgebildet sind und das Mikro-Blenden-Array in der Projektionseinrichtung derart angeordnet ist, dass die Projektionseinrichtung zum Bilden einer Abblendlichtverteilung und/oder einer Teilfernlichtverteilung oder einer Fernlichtverteilung eingerichtet ist. Die Mikro-Blenden können dabei entsprechend geformte optisch wirksame Kanten aufweisen.

Besonders kompakte Projektionseinrichtung ergibt sich, wenn die Mikrooptiken des zumindest einen Mikrooptik-Arrays gleiche Höhe, beispielsweise in einem Bereich zwischen etwa 0,01mm und etwa 2mm, vorzugsweise zwischen etwa 0,1mm und etwa 1,5mm, insbesondere eine Höhe von etwa 1,1mm aufweisen.

Bei drei Substratschichten und zwei Mikrooptik-Arrays, wobei eine mittlere Substratschicht zwischen einer ersten Substratschicht und einer zweiten Substratschicht angeordnet ist, wobei eine erste Fläche der ersten Substratschicht, an der ein erstes Mikrooptik-Array ausgebildet ist und haftet, und eine erste Fläche der zweiten Substratschicht, an der ein zweites Mikrooptik-Array ausgebildet ist und haftet, der mittleren Substratschicht abgewandt sind, wobei das zumindest eine Mikro-Blenden-Array an einer zweiten Fläche der ersten oder der zweiten Substratschicht oder an einer der zwei Flächen der mittleren Substratschicht angeordnet ist.

Dabei kann vorgesehen sein, dass zumindest zwei Mikro-Blenden-Arrays vorgesehen sind, wobei vorzugsweise ein erstes Mikro-Blenden-Array zum Formen einer Abblendlichtverteilung und/oder einer Teilfernlichtverteilung oder einer Fernlichtverteilung ausgebildet ist und ein zweites Mikro-Blenden-Array zum Korrigieren von Abbildungsfehlern vorgesehen ist.

Besondere Vorteile ergeben sich, wenn die drei Substratschichten miteinander verbunden, vorzugsweise verklebt sind. Dabei wird das Geraten von Schmutz in optisch relevante Bereiche der Projektionseinrichtung verringert und gleichzeitig Stabilität erhöht. Beispielsweise kann zwischen der ersten und der zweiten Substratschicht kein Staub mehr geraten.

Um für einen Einsatz in einem Kraftfahrzeugscheinwerfer geeignet zu sein, müssen die Projektionseinrichtungen eine Reihe von Umweltanforderungen und Prüfungen bestehen (Temperatur, Luftfeuchte, Staub, rütteln, lichttechnische Werte, Alterung und viel mehr). Bei herkömmlichen Projektionseinrichtungen bei welchen beispielsweise Kunststoffspritzgußteile und Strahlenblenden aus Blech kann es durch Luftfeuchtigkeit und Staub zu Verschmutzungen innerhalb des Lichtpfades kommen. Durch eine direkte Verbindung, beispielsweise Verklebung, ist dies nicht mehr möglich.

Die Aufgabe der Erfindung wird außerdem mit einem Kraftfahrzeugscheinwerferlichtmodul beziehungsweise Kraftfahrzeugscheinwerfer gelöst. Dabei umfasst das erfindungsgemäße Kraftfahrzeugscheinwerferlichtmodul beziehungsweise der erfindungsgemäße Kraftfahrzeugscheinwerfer zumindest eine erfindungsgemäße Projektionseinrichtung und zumindest eine Lichtquelle, vorzugsweise eine halbleiterbasierte Lichtquelle, insbesondere eine LED-Lichtquelle, wobei die zumindest eine Projektionseinrichtung der zumindest einen Lichtquelle in Abstrahlrichtung derart nachgelagert ist, dass die zumindest eine Lichtquelle im Wesentlichen ihr gesamtes Licht in die zumindest eine Projektionseinrichtung einstrahlt und die zumindest eine Projektionseinrichtung das in sie eingestrahlte Licht in einen Bereich vor das Kraftfahrzeugscheinwerferlichtmodul beziehungsweise vor den Kraftfahrzeugscheinwerfer in Form einer Abblendlichtverteilung und/oder einer Teilfernlichtverteilung oder einer Fernlichtverteilung projiziert.

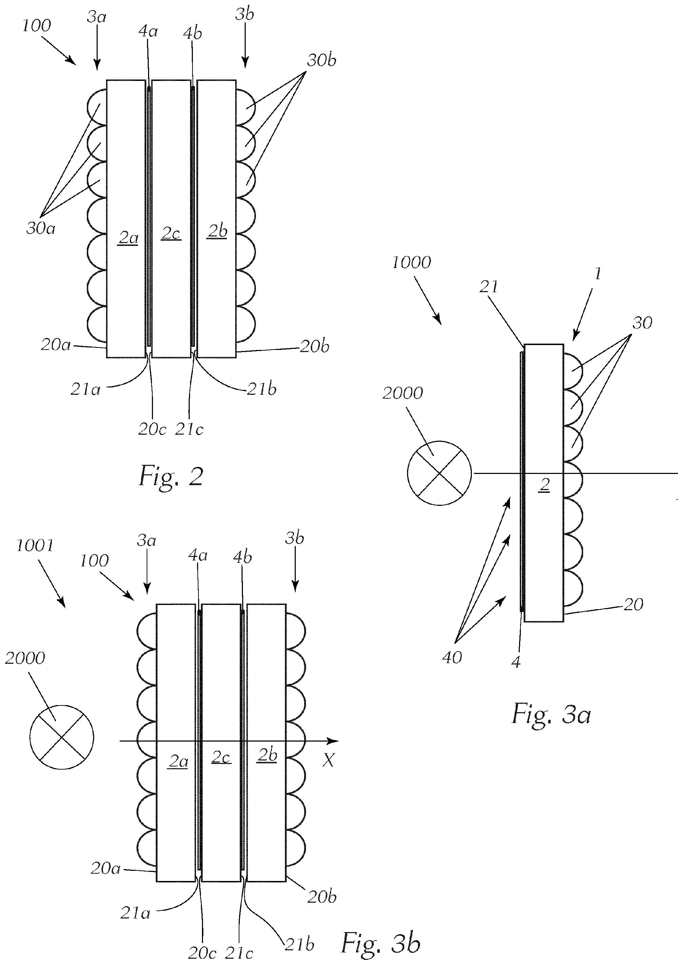

Dabei ist die Lichtquelle vorzugsweise nah genug an der Projektionseinrichtung positioniert. "Nah genug" bedeutet im vorliegenden Kontext, dass die Lichtquelle derart hinsichtlich der Projektionseinrichtung angeordnet ist, dass im Wesentlichen gesamtes von der Lichtquelle abgegebenes Licht in die Projektionseinrichtung eingespeist wird und die Lichtquelle dabei im Wesentlichen gesamte Lichteintrittsseite der Projektionseinrichtung, beispielsweise die ganze zweite Fläche 21 in Figur 3a oder das ganze erste Mikrooptik-Array 3a in Figur 3b, ausleuchtet.

Darüber hinaus wird die Aufgabe mit einem Verfahren zum Herstellen einer Projektionseinrichtung, insbesondere einer vorgenannten erfindungsgemäßen Projektionseinrichtung, erfindungsgemäß dadurch gelöst, dass das Verfahren folgende Schritte aufweist:
- Bereitstellen von
   * transparentem Silikon;
   * zumindest einer Substratschicht aus einem transparenten, formstabilen Material, beispielsweise aus Glas, wobei die Substratschichaufdruckent formstabiler als das transparente Silikon ist, und
   * zumindest einem aus einer Mehrzahl von Mikro-Blenden bestehenden Mikro-Blenden-Arrays;
- Ausbilden zumindest eines aus einer Mehrzahl von Mikrooptiken bestehenden Mikrooptik-Arrays aus dem transparenten Silikon an einer ersten Fläche der zumindest einen Substratschicht und
- Anordnen des zumindest einen Mikro-Blenden-Arrays an einer zweiten Fläche der zumindest einen Substratschicht, wobei das zumindest eine Mikrooptik-Array und das zumindest eine Mikro-Blenden-Array derart zueinander angeordnet sind, dass jeder Mikro-Blende zumindest eine Mikrooptik zugeordnet ist, und das transparente Silikon vorzugsweise eine Shore-A-Härte von etwa 30 bis etwa 100, insbesondere von etwa 40 bis etwa 90 aufweist, insbesondere ein Zwei-Komponenten-Silikon ist.

Es sei an dieser Stelle angemerkt, dass das Anordnen/Positionieren des Mikro-Blenden-Arrays hinsichtlich des Mikrooptik-Arrays kann vor oder nach dem Ausbilden des Mikrooptik-Arrays in der Negativform erfolgen.

Bei einer bevorzugten Ausführungsform kann vorgesehen sein, dass das Ausbilden zumindest eines aus einer Mehrzahl von Mikrooptiken bestehenden Mikrooptik-Arrays aus dem transparenten Silikon an einer ersten Fläche der zumindest einen Substratschicht folgende Teilschritte umfasst:
- Bereitstellen zumindest einer Negativform mit einer formgebenden Oberfläche, die dem zumindest einen Mikrooptik-Array entspricht;
- Gießen des transpatenten Silikons in die zumindest eine Negativform;
- Aufsetzten/Auflegen der zumindest einen Substratschicht auf die zumindest eine Negativform;
- Aushärten des Silikons in der zumindest einen Negativform, und
- Entformen des Mikrooptik-Arrays aus der zumindest einen Negativform.

Dabei kann es zweckmäßig sein, wenn während des Aushärtens des Silikons der zumindest einen Negativform, insbesondere der formgebenden Oberfläche, Wärme zugeführt wird und vor dem Entformen die zumindest eine Negativform gekühlt wird. Dadurch wird die Zeit, die zum Herstellen einer Projektionseinrichtung gebraucht wird, erheblich reduziert.

Die Negativform kann beispielsweise aus Messing ausgebildet sein - Messingkörper.

Bei einer praxisbewährten Ausführungsform kann vorgesehen sein, dass die zumindest eine Negativform während des Aushärtens des Silikons auf eine vorbestimmte erste Temperatur erhitzt wird, wobei die erste Temperatur beispielsweise in einem Bereich zwischen etwa 90° C und etwa 200° C, vorzugsweise zwischen etwa 100° C und etwa 150° C, insbesondere zwischen etwa 100° C und etwa 120° C oder etwa 120° C und etwa 150° C liegt, und bei der vorbestimmten ersten Temperatur für eine vorzugsweise von der vorbestimmten ersten Temperatur abhängige Dauer gehalten wird, wobei die Dauer beispielsweise zwischen etwa 0,5 Minuten und 6 Minuten, vorzugsweise zwischen 1 Minute und 5 Minuten beträgt. Darüber hinaus kann es zweckdienlich sein, wenn die zumindest eine Negativform auf eine vorbestimmte zweite Temperatur gekühlt wird, wobei die zweite Temperatur beispielsweise in einem Bereich zwischen etwa 40° C und etwa 70° C, vorzugsweise zwischen etwa 50° C und etwa 60° C liegt.

Dafür kann eine entsprechende Kühlvorrichtung vorgesehen sein, die beispielsweise der Negativform zugeordnet beziehungsweise an oder in der Negativform angeordnet sein kann. Es ist denkbar, dass die Kühlvorrichtung mit Druckluft und/oder Kühlflüssigkeit kühlt.

Hinsichtlich Hafteigenschaften kann es zweckmäßig sein, wenn die erste Fläche der zumindest einen Substratschicht vor dem Aufsetzten/ Auflegen der zumindest einen Substratschicht auf die zumindest eine Negativform vorbehandelt wird.

Die Vorbehandlung kann beispielsweise mit SurASil®- Technik erfolgen. SurASil®- Technik ist ein Verfahren zur Behandlung von Oberflächen zur Beeinflussung der Haftfestigkeit von Klebstoffen, Beschichtungen und Druckmedien mittels Beflammung ist ein seit Jahren etabliertes Verfahren in zahlreichen industriellen Bereichen (wie z. B. Sieb-, Tampon-, Digital-, und Textildruck). Eine weitere signifikante Verbesserung der Haftfestigkeit kann durch Abschneidung einer reaktiven Silikatschicht, die durch Flammenpyrolyse erzeugt wird erreicht werden.

Dabei kann es mit Vorteil vorgesehen sein, dass die Vorbehandlung folgende Teilschritte umfasst:
- Reinigen zumindest der ersten Fläche;
- Oberflächenvorbehandlung der ersten Fläche durch Flammensilikatisierung.

Die Oberflächenbehandlung durch Flammensilikatisierung kann beispielsweise erstens in der Erzeugung einer hochenergetischen Silikatschicht (Schichtdicke max 40nm) auf den Materialoberflächen durch Flammenpyrolyse (Oberflächensilikatisierung) und zweitens in der Applikation eines Haftpromotors mit angepasster Funktionalität an den Klebstoff, die Beschichtung beziehungsweise an das Druckmedium und im Kontext der vorliegenden Erfindung an die erste Fläche der zumindest einen Substratschicht bestehen.

Darüber hinaus kann mit Vorteil vorgesehen sein, dass das Anordnen des zumindest einen Mikro-Blenden-Arrays an einer zweiten Fläche der zumindest einen Substratschicht folgende Teilschritte umfasst:
- Aufbringen des zumindest einen Mikro-Blenden-Arrays auf die zweite Fläche der zumindest einen Substratschicht;
- Positionieren des zumindest einen Mikro-Blenden-Array hinsichtlich des zumindest einen Mikrooptik-Arrays derart, dass jeder Mikro-Blende zumindest eine Mikrooptik zugeordnet ist.

Das Aufbringen kann beispielsweise durch Aufdrucken, insbesondere mittels eines lithographischen Verfahrens, oder durch Verkleben erfolgen.

Es sei an dieser Stelle angemerkt, dass die Schritte des Aufbringens und des Positionierens in ihrer Reihenfolge vertauschbar sind. Es ist also möglich das zumindest eine Mikro-Blenden-Array auf die zweite Fläche aufzubringen und es danach (mit der zumindest einen Substratschicht) hinsichtlich des noch nicht ausgehärteten Mikrooptik-Arrays, beispielsweise hinsichtlich der formgebenden Oberfläche der Negativform derart zu positionieren, dass einer jeden Mikro-Blende zumindest eine Mikrooptik zugeordnet wird, wenn das Silikon ausgehärtet ist. Weiters ist es denkbar, dass das zumindest eine Mikro-Blenden-Array erst nach dem Aushärten des Silikons in der Negativform hinsichtlich des Mikrooptik-Arrays positioniert und anschließend, wie oben beschrieben, auf die zweite Fläche aufgebracht wird.

Darüber hinaus kann mit Vorteil vorgesehen sein, dass zumindest drei Substratschichten aus einem transparenten, formstabilen Material, beispielsweise aus Glas bereitgestellt werden, wobei eine mittlere Substratschicht zwischen einer ersten Substratschicht und einer zweiten Substratschicht derart angeordnet wird, dass eine erste Fläche der ersten Substratschicht und eine erste Fläche der zweiten Substratschicht der mittleren Substratschicht abgewandt sind,
- ein erstes aus einer Mehrzahl von Mikrooptiken bestehendes Mikrooptik-Array aus transparentem Silikon an der ersten Fläche der ersten Substratschicht ausgebildet wird,
- ein zweites aus einer Mehrzahl von Mikrooptiken bestehendes Mikrooptik-Array aus transparentem Silikon an der ersten Fläche der zweiten Substratschicht ausgebildet wird,
- das zumindest eine Mikro-Blenden-Array an einer zweiten Fläche der ersten Substratschicht oder an einer zweiten Fläche der zweiten Substratschicht oder an einer der zwei Flächen der mittleren Substratschicht derart angeordnet wird, dass jeder Mikro-Blende zumindest eine, vorzugsweise genau eine Mikrooptik des ersten Mikrooptik-Arrays und zumindest eine, vorzugsweise genau eine Mikrooptik des zweiten Mikrooptik-Arrays zugeordnet ist und vorzugsweise ein Mikro-Optiksystem bilden. Dabei, wenn die Projektionseinrichtung mit Licht durchstrahlt wird, formt jedes Mikro-Optiksystem eine so genannte Mikro-Lichtverteilung. Durch eine Überlagerung mehrerer Mikro-Lichtverteilung wird typischerweise eine Teil-Lichtverteilung oder eine Gesamtlichtverteilung erzeugt.

Es kann außerdem zweckdienlich sein, dass zum Ausbilden von dem ersten Mikrooptik-Array und von dem zweiten Mikrooptik-Array unterschiedliche transparente Silikone zu verwenden.

Bezugnehmend auf die vorgenannte bevorzugte Ausführungsform des Verfahrens, bei welcher eine Negativform verwendet wurde, sei angemerkt, dass zum Ausbilden des ersten und des zweiten Mikrooptik-Arrays jeweils unterschiedliche Negativformen, vorzugsweise Negativformen mit unterschiedlich ausgebildeten formgebenden Flächen verwendet werden können. Dadurch werden Mikrooptik-Arrays mit unterschiedlichen optischen Wirkungen erzeugt.

Es kann weiters mit Vorteil vorgesehen sein, dass die drei Substratschichten verbunden, vorzugsweise verklebt werden.

Darüber hinaus ist es denkbar das vorgenannte Verfahren zu automatisieren und dadurch zu beschleunigen, wenn die Negativform und die zumindest eine Substratschicht mit dem zumindest einen an ihr angeordneten Mikro-Blenden-Array in ein Fördersystem eingebracht werden.

Die Erfindung ist im Folgenden anhand beispielhafter und nicht einschränkender Ausführungsformen näher erläutert, die in den Figuren veranschaulicht sind. Darin zeigt
Fig. 1a eine Projektionseinrichtung mit einer Substratschicht in Explosionsdarstellung;
Fig. 1b ein vertikaler Schnitt der Projektionseinrichtung der Fig. 1a;
Fig. 2 eine Projektionseinrichtung mit drei Substratschichten;
Fig. 3a ein Kraftfahrzeugscheinwerferlichtmodul mit der Projektionseinrichtung der Figur 1a beziehungsweise 1b;
Fig. 3b ein Kraftfahrzeugscheinwerferlichtmodul mit der Projektionseinrichtung der Figur 2;
Fig. 4 ein mit schematischen Zeichnungen versehenes Ablaufdiagramm eines Herstellungsverfahrens gemäß einer Ausführungsform;
Fig. 5 ein mit schematischen Zeichnungen versehenes Ablaufdiagramm eines Herstellungsverfahrens gemäß einer weiteren Ausführungsform;
Fig. 6 eine Anlage zum Herstellen von Projektionseinrichtungen, und
Fig. 7a bis 7d lithographisches Druckverfahren zum Aufbringen eines Mikro-Blenden-Arrays auf eine transparente Substratschicht.

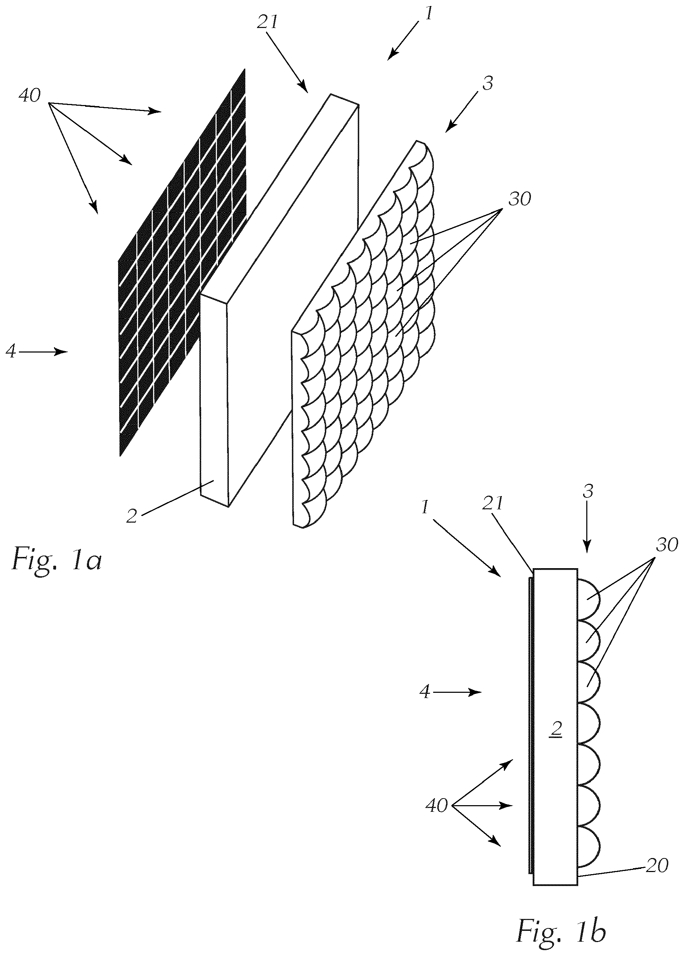

Zunächst wird auf Figuren 1a und 1b Bezug genommen. Figur 1a zeigt eine Explosionsdarstellung einer Projektionseinrichtung 1, die einer erfindungsgemäßen Projektionseinrichtung entsprechen kann. Figur 1b zeigt einen vertikalen Schnitt der in Figur 1a gezeigten Projektionseinrichtung 1. Die Projektionseinrichtung 1 umfasst eine Substratschicht 2, ein aus einer Mehrzahl von Mikrooptiken 30 bestehendes Mikrooptik-Array 3 und ein aus einer Mehrzahl von Mikro-Blenden 40 bestehendes Mikro-Blenden-Array 4. Vorzugsweise weisen die Mikrooptiken 30, wie Figuren 1a und 1b erkennen lassen, eine plane Seite auf und sind beispielsweise als plankonvexe Linsen ausgebildet. Die Mikrooptiken 30 können auch plankonkave oder andere Mikrolinsen, beispielsweise Mikrolinsen mit einer freiförmigen Lichtaustrittsfläche sein. Das Mikrooptik-Array 3 weist somit vorzugsweise eine durchgehende plane Fläche auf, die durch die planen Seiten der einzelnen Mikrooptiken 30 gebildet ist. Die Mikrooptiken können matrixartig, vorzugsweise in einer Ebene, angeordnet sein, welche Ebene zu einer Hauptabstrahlrichtung X eines Kraftfahrzeugscheinwerferlichtmoduls **1000, 1001** (siehe Figuren 3a, 3b) steht, wenn die Projektionseinrichtung 1 darin angeordnet ist. Solche Mikrooptik-Arrays sind aus dem Stand der Technik hinlänglich bekannt (siehe z.B. die AT 514967 B1). Die Substratschicht 2 und das Mikrooptik-Array 3 sind aus verschiedenen Materialien ausgebildet und weisen unterschiedliche Formstabilität, Festigkeit und Stabilität auf. Auf die Beschaffenheit der Substratschicht 2 und des Mikrooptik-Arrays 3 wird noch später eingegangen.

Das Mikrooptik-Array 3 ist an einer ersten Fläche 20 der Substratschicht 2 ausgebildet und haftet an dieser Fläche beispielsweise aufgrund Kohäsion und/oder Adhäsion.

Das Mikro-Blenden-Array 4 ist an einer zweiten Fläche 21 der Substratschicht 2 derart angeordnet, dass jeder Mikro-Blende 40 genau eine Mikrooptik 30 zugeordnet sein kann. Dies ist besonders gut in der Figur 1a zu erkennen. Jeder Mikro-Blende 40 können auch mehrere Mikrooptiken zugeordnet sein (nicht gezeigt). Somit ist ein optisches System aus Mikro-Blende und Mikrooptik justiert. Wenn die Projektionseinrichtung 1 beleuchtet wird, formen durch eine Mikro-Blende 40 und zumindest eine ihr zugeordnete Mikrooptik 30 durchtretende Lichtstrahlen eine Mikro-Lichtverteilung. Eine Lichtverteilung, die mittels der Projektionseinrichtung 1 geformt werden kann, entsteht als eine Überlagerung aller Mikro-Lichtverteilungen (siehe AT 514967 B1).

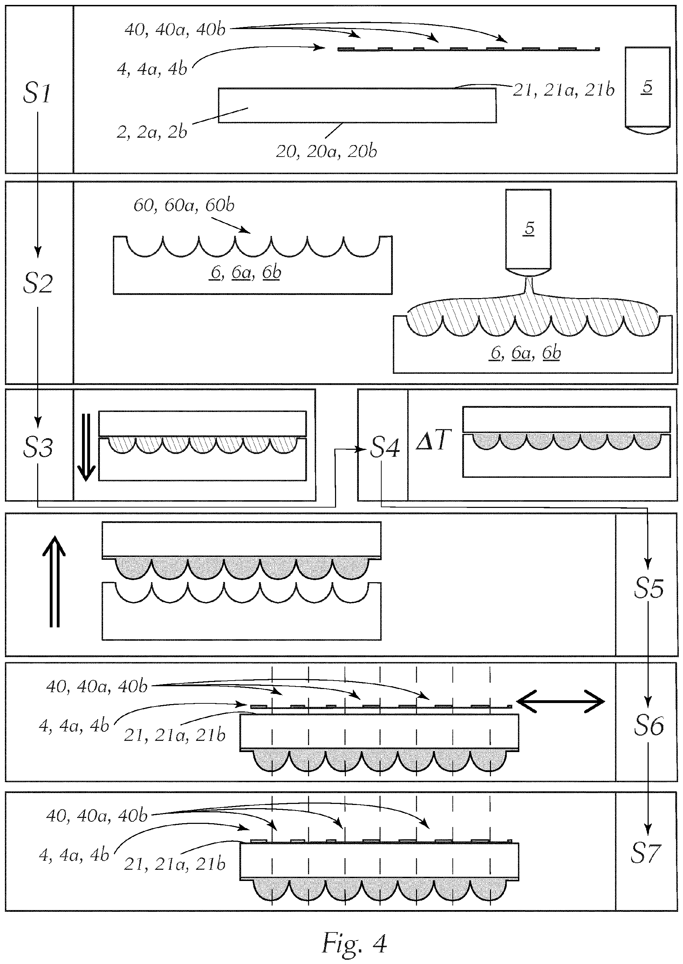

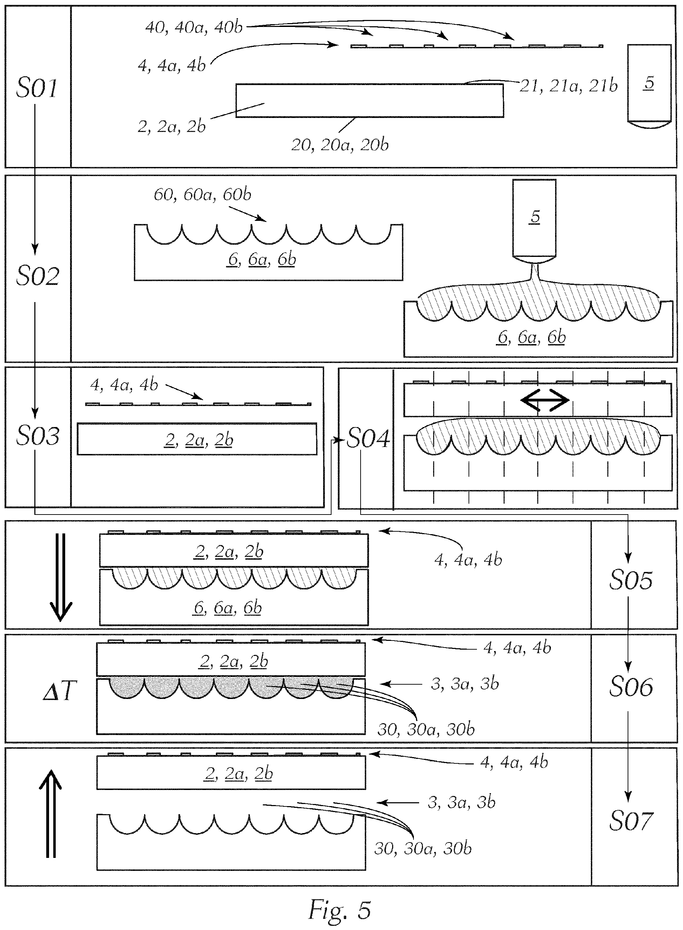

Wie bereits erwähnt, sind die Substratschicht 2 und das Mikrooptik-Array 3 aus verschiedenen Materialien ausgebildet. Erfindungsgemäß ist das Mikrooptik-Array 3 aus einem transparenten Silikon 5 (siehe Figuren 4 und 5) ausgebildet, wobei die Substratschicht 2 aus einem transparenten Material ausgebildet ist, welches formstabiler als das transparente Silikon 5 ist.

Die Substratschicht 2 soll aus einem Material sein, das eine gute Lichttransparenz aufweist und gleichzeitig formstabil genug ist. Formstabil genug heißt in diesem Kontext, dass die Substratschicht 2 das Mikrooptik-Array 3 aus (weichem, lichttransparenten) Silikon 5 trägt und sowohl während des Ausbildens des Mikrooptik-Arrays 3 an der ersten Fläche 20 der Substratschicht 2 als auch während des Anbringens des Mikro-Blenden-Arrays 4 an die zweite Fläche 21 aber auch während des Einsatzes der Projektionseinrichtung 1 in einem Kraftfahrzeugscheinwerfer ihre Form nicht verliert.

Die formstabile Substratschicht 2 kann also als Träger für das Mikrooptik-Arrays 3 dienen. Die formstabile Substratschicht 2 kann auch als Träger für Mikro-Blenden-Arrays 4. Es ist zweckmäßig, wenn das Mikro-Blenden-Array 4 und das Mikrooptik-Array 3 aufeinander genau abgestimmt beziehungsweise justiert sind, damit ein Lichtbild ohne Verzerrungen erzeugt werden kann. Die Form der Silikonschicht 2 legt im Wesentlichen die optischen Eigenschaften der gesamten Projektionseinrichtung 1, wie beispielsweise ihre Brennweite, fest. Durch Formstabilität der Substratschicht 2 soll insbesondere gewährleistet werden, dass die fertige Projektionseinrichtung 1 den mechanischen Standardanforderungen von Hauptscheinwerfersystemen Rechnung trägt, und insbesondere Schock- und Vibrationsanforderungen der jeweiligen KFZ-Hersteller genügt. Bezüglich Vibrations- und Schockanforderungen gibt es verschiedene, dem Fachmann hinlänglich bekannte Prüfungen. Die Schockanforderungen können zwischen 18 g und 50 g (je nach Achse) schwanken. Im Prinzip kann die Substratschicht 2 aus jedem optisch transparenten Material sein, welches die Stabilität und die Scheinwerferanforderungen (Q-Anforderungen und gesetzliche Reglementierungen, wie beispielsweise EU Altautoverordnung) erfüllt.

Das Mikrooptik-Array 3 ist vorzugsweise mittels eines thermischen Abformverfahrens, auf welches später eingegangen wird, ausgebildet und zum Haften an der ersten Fläche 20 der Substratschicht 2 gebracht. Darüber hinaus ist es durchaus denkbar, dass das Mikrooptik-Array 3 und die Substratschicht 2 unterschiedliche Brechungsindizes aufweisen.

Die Substratschicht 2 ist vorzugsweise aus Glas. Die Substratschicht 2 kann eine Dicke im Millimeterbereich aufweisen, beispielsweise etwa 1,1 mm dick sein. Die Silikonschicht 3 kann ebenfalls eine Dicke im Millimeterbereich aufweisen, beispielsweise etwa 0,1 mm bis 1,1 mm dick sein.

Das transparente Silikon 5 weist vorzugsweise eine Shore-A-Härte von etwa 30 bis etwa 100, insbesondere von etwa 40 bis etwa 90 auf. Besonders vorteilhaft ist die Verwendung von transparentem Zwei-Komponenten-Silikon mit einer solchen Shore-A-Härte.

Die Mikro-Blenden 40 sind vorzugsweise derart ausgebildet und das Mikro-Blenden-Array 4 ist vorzugsweise in der Projektionseinrichtung 1 derart angeordnet, dass die Projektionseinrichtung 1 zum Bilden einer Abblendlichtverteilung und/oder einer Teilfernlichtverteilung oder einer Fernlichtverteilung eingerichtet ist. Beispielsweise können die Mikro-Blenden 40 entsprechend geformte optisch wirksame Kanten aufweisen.

Die Mikrooptiken 30 des Mikrooptik-Arrays 3 können gleich hoch sein und beispielsweise eine Höhe in einem Bereich zwischen etwa 0,01 mm und etwa 2 mm, vorzugsweise zwischen etwa 0,1 mm und etwa 1,5 mm, insbesondere eine Höhe von etwa 1,1 mm aufweisen.

Figur 2 zeigt eine weitere Projektionseinrichtung **100,** die einer erfindungsgemäßen Projektionseinrichtung entsprechen kann. Die Projektionseinrichtung 100 umfasst drei Substratschichten **2a, 2b, 2c,** zwei Mikrooptik-Arrays **3a, 3b** und zwei Mikro-Blenden-Arrays **4a, 4b.** Figur 2 lässt erkennen, dass die Projektionseinrichtung 100 im Wesentlichen aus zwei Projektionseinrichtungen 1 der Figur 1a beziehungsweise 1b zusammengesetzt ist und darüber hinaus eine zusätzliche Substratschicht 2c aufweist. Aus diesem Grund findet das in Bezug auf die Projektionseinrichtung 1 der Figur 1a beziehungsweise 1b Gesagte auf die Projektionseinrichtung 100 der Figur 2 - unter Umständen mit entsprechenden Abänderungen - Anwendung. Beispielsweise können alle Substratschichten aus Glas sein. Dabei können unterschiedliche Substratschichten 2a, 2b, 2c und unterschiedliche Mikrooptik-Arrays 3a, 3b jeweils unterschiedliche Brechungsindizes aufweisen.

Figur 2 lässt erkennen, dass eine mittlere Substratschicht 2c zwischen einer ersten Substratschicht 2a und einer zweiten Substratschicht 2b angeordnet sein kann. Dabei ist eine erste Fläche **20a** der ersten Substratschicht 2a abgewandt und eine erste Fläche **20b** ist der zweiten Substratschicht 2b der mittleren Substratschicht 2c abgewandt. Ein erstes Mikrooptik-Array 3a ist an der ersten Fläche 20a der ersten Substratschicht 2a ausgebildet und haftet daran. Ein zweites Mikrooptik-Array 3b ist an der ersten Fläche 20b der zweiten Substratschicht 2b ausgebildet und haftet daran.

Figur 2 ist zu entnehmen, dass ein erstes Mikro-Blenden-Array **4a** an einer zweiten Fläche **21a** der ersten Substratschicht 2a angeordnet ist und ein zweites Mikro-Blenden-Array **4b** an einer zweiten Fläche **21b** der zweiten Substratschicht 2b angeordnet ist. Beide Mikro-Blenden-Arrays 4a und 4b können dabei auf die entsprechenden Flächen **20c, 21c** der mittleren Substratschicht 2c aufgebracht oder, beispielsweise durch ein lithographisches Druckverfahren, aufgedruckt sein. Somit kann die mittlere Substratschicht 2c als Träger für die Mikro-Blenden-Arrays 4a, 4b dienen. Lithographisches Drucken kann zum Anbringen des Mikro-Blenden-Arrays 4 auf die Substratschicht 2 der vorgenannten Projektionseinrichtung 1 ebenfalls angewandt werden.

Beispielsweise kann das erste Mikro-Blenden-Array 4a zum Formen einer Abblendlichtverteilung und/oder einer Teilfernlichtverteilung oder einer Fernlichtverteilung ausgebildet sein und das zweite Mikro-Blenden-Array 4b zum Korrigieren von Abbildungsfehlern vorgesehen sein.

Weiters können die drei Substratschichten 2a, 2b, 2c miteinander verbunden, vorzugsweise verklebt sein, um Stabilität der Projektionseinrichtung 100 zu verbessern und die Mikro-Blenden-Arrays 4a und 4b in der justierten Position zu versiegeln.

Figuren 3a und 3b zeigen jeweils Kraftfahrzeugscheinwerferlichtmodule 1000 und 1001 mit jeweils einer Lichtquelle **2000,** beispielsweise einer halbleiterbasierten Lichtquelle, und einer entsprechenden oben beschriebenen Projektionseinrichtung 1, 100, die der jeweiligen Lichtquelle in Hauptabstrahlrichtung X nachgelagert ist. Dabei strahlt die zumindest eine Lichtquelle 2000 beispielsweise ihr gesamtes Licht in die Projektionseinrichtung 1, 100 ein. Die Projektionseinrichtung 1, 100 kann das in sie eingestrahlte Licht in einen Bereich vor das Kraftfahrzeugscheinwerferlichtmodul 1000, 1001 beziehungsweise vor den Kraftfahrzeugscheinwerfer in Form einer Abblendlichtverteilung und/oder einer Teilfernlichtverteilung oder einer Fernlichtverteilung projizieren.

Im weiteren Verlauf soll unter Bezugnahme auf Figuren 4 und 5 ein Verfahren zum Herstellen der oben beschriebenen Projektionseinrichtungen 1,100 umrissen werden. Figuren 4 und 5 zeigen jeweils ein solches Verfahren, das dem erfindungsgemäßen Verfahren entsprechen kann.

Zunächst wird auf Figur 4 Bezug genommen. In einem ersten Schritt **S1** des Verfahrens werden transparentes Silikon 5, eine Substratschicht 2, 2a, 2b aus einem transparenten, formstabilen Material, beispielsweise aus Glas, wobei die Substratschicht 2, 2a, 2b formstabiler als das transparente Silikon 5 ist, und ein aus einer Mehrzahl von Mikro-Blenden **40, 40a, 40b** bestehenden Mikro-Blenden-Array 4, 4a, 4b bereitgestellt. Dieser Schritt ist einem ersten Schritt - **S01** - des in Figur 5 gezeigten Verfahrens identisch. Das transparente Silikon 5 weist vorzugsweise eine Shore-A-Härte von etwa 30 bis etwa 100, insbesondere von etwa 40 bis etwa 90 auf. Ein Zwei-Komponenten-Silikon wird dabei bevorzugt.

Anschließend wird ein aus einer Mehrzahl von Mikrooptiken 30, **30a, 30b** bestehendes Mikrooptik-Array 3, 3a, 3b aus dem transparenten Silikon 5 an einer ersten Fläche 20, 20a, 20b der Substratschicht 2, 2a, 2b vorzugsweise wie folgt ausgebildet.

In einem zweiten Schritt **S2** wird eine Negativform **6, 6a, 6b,** beispielsweise aus Messing (ein Messingkörper), mit einer formgebenden Oberfläche **60, 60a, 60b,** die dem Mikrooptik-Array 3, 3a, 3b entspricht, bereitgestellt und das transpatente Silikons 5 darin gegossen beziehungsweise in die Negativform 6, 6a, 6b dosiert. Dieser Schritt ist einem zweiten Schritt - **S02** - des in Figur 5 gezeigten Verfahrens identisch.

In einem dritten Schritt **S3** wird die Substratschicht 2, 2a, 2b auf die Negativform 6, 6a, 6b aufgesetzt beziehungsweise aufgelegt.

Anschließend wird in einem vierten Schritt - **S4** - das Silikon 5 in der Negativform 6, 6a, 6b ausgehärtet. Das in der Negativform 6, 6a, 6b ausgehärtete, vernetzte Silikon 5 wird zum Mikrooptik-Array 3, 3a, 3b.

Das Mikrooptik-Array 3, 3a, 3b kann anschließend aus der Negativform 6, 6a, 6b entformt werden - fünfter Schritt **S5.**

Es versteht sich, dass mehrere Negativformen 6, 6a, 6b mit unterschiedlich geformten formgebenden Oberflächen 60, 60a, 60b bereitgestellt werden können, um unterschiedliche Mikrooptik-Arrays 3, 3a, 3b zu erzeugen. Beispielsweise kann sich das Mikrooptik-Array 3a in Figuren 2, 3a, 3b, das als Mikro-Eintrittsoptik eingesetzt wird, von dem Mikrooptik-Array 3b, das als Mikro-Austrittsoptik verwendet wird, unterscheiden. Dadurch können beispielsweise Projektionseinrichtungen mit Mikrooptik-Arrays erzeugt werden, die unterschiedlich gekrümmte Mikro-Eintrittsoptiken und Mikro-Austrittsoptiken aufweisen. Solche Projektionseinrichtungen ermöglichen eine besonders feine Einstellung einer zu erzeugenden Lichtverteilung. Wie bereits erwähnt, müssen die Mikrooptik-Arrays 3a, 3b und die Mikrooptiken 30a, 30b der Projektionseinrichtung 100 der Figur 2 und das Mikrooptik-Array 3 und die Mikrooptiken 30 der Projektionseinrichtung 1 der Figur 1a beziehungsweise 1b nicht identisch sein.

Figur 4 lässt erkennen, dass während des Aushärtens des Silikons 5 (Schritt S4) der Negativform 6, 6a, 6b und insbesondere ihrer formgebenden Oberfläche 60, 60a, 60b Wärme zugeführt und vor dem Entformen (Schritt S5) die Negativform 6, 6a, 6b gekühlt werden kann. Dabei kann die zumindest eine Negativform 6, 6a, 6b auf eine vorbestimmte erste Temperatur erhitzt werden, wobei die erste Temperatur beispielsweise in einem Bereich zwischen etwa 90° C und etwa 200° C, vorzugsweise zwischen etwa 100° C und etwa 150° C, insbesondere zwischen etwa 100° C und etwa 120° C oder etwa 120° C und etwa 150° C liegt, und bei der vorbestimmten ersten Temperatur für eine vorzugsweise von der vorbestimmten ersten Temperatur abhängige Dauer gehalten werden kann, wobei die Dauer beispielsweise zwischen etwa 0,5 Minuten und 6 Minuten, vorzugsweise zwischen 1 Minute und 5 Minuten beträgt. Beim Kühlen wird die Negativform 6, 6a, 6b auf eine vorbestimmte zweite Temperatur vorzugsweise mittels Druckluft und/oder Kühlflüssigkeit gekühlt, wobei die zweite Temperatur beispielsweise in einem Bereich zwischen etwa 40° C und etwa 70° C, vorzugsweise zwischen etwa 50° C und etwa 60° C liegt.

Anschließend wird das Mikro-Blenden-Arrays 4, 4a, 4b an einer zweiten Fläche 21, 21a, 21b der zumindest einen Substratschicht 2, 2a, 2b angeordnet, wobei das zumindest eine Mikrooptik-Array 3, 3a, 3b und das zumindest eine Mikro-Blenden-Array 4, 4a, 4b derart zueinander angeordnet sind, dass jeder Mikro-Blende 40, 40a, 40b zumindest eine Mikrooptik 30, 30a, 30b derart zugeordnet ist, dass die Mikro-Blende 40, 40a, 40b die zumindest eine ihr zugeordnete Mikrooptik 30, 30a, 30b ein justiertes optisches Projektionssystem bilden. Dabei weist das Anordnen des Mikro-Blenden-Arrays 4, 4a, 4b an der zweiten Fläche 21, 21a, 21b der Substratschicht 2, 2a, 2b vorzugsweise folgende Teilschritte auf. Schritt **S6** - das sogenannte Alignen - besteht im Positionieren des zumindest einen Mikro-Blenden-Array 4, 4a, 4b hinsichtlich des zumindest einen Mikrooptik-Arrays 3, 3a, 3b derart, dass jeder Mikro-Blende 40, 40a, 40b zumindest eine Mikrooptik 30, 30a, 30b zugeordnet ist. Anschließend - in einem siebenten Schritt **S7** - wird das Mikro-Blenden-Array 4, 4a, 4b auf die zweite Fläche 21, 21a, 21b der Substratschicht 2, 2a, 2b aufgebracht, beispielsweise verklebt oder aufgedruckt, insbesondere mittels eines lithographischen Druckverfahrens aufgetragen. Es sei an dieser Stelle angemerkt, dass das Mikro-Blenden-Array 4, 4a, 4b auf einer weiteren Substratschicht, wie die mittlere Substratschicht 2c in den Figuren 2 und 3b, bereits aufgebracht sein kann.

Das Aufbringen und das Alignen des Mikro-Blenden-Arrays 4, 4a, 4b auf die Substratschicht 2, 2a, 2b können in unterschiedlichen Stadien des erfindungsgemäßen Verfahrens stattfinden hinsichtlich des Mikrooptik-Arrays kann vor oder nach dem Ausbilden des Mikrooptik-Arrays in der Negativform (Aussetzen, Aushärten, Entformen) erfolgen. Figur 5 zeigt eine Ausführungsform des erfindungsgemäßen Verfahrens, bei welcher das Mikro-Blenden-Array 4, 4a, 4b bereits in einem dritten Schritt S03 auf die zweite Fläche 21, 21a, 21b der Substratschicht 2, 2a, 2b aufgebracht wird, vorzugsweise verklebt oder aufgedruckt, insbesondere mittels eines lithographischen Druckverfahrens aufgetragen wird. Es sei an dieser Stelle angemerkt, dass das Mikro-Blenden-Array 4, 4a, 4b auf einer weiteren Substratschicht, wie die mittlere Substratschicht 2c in den Figuren 2 und 3b, bereits aufgebracht sein kann. Das anschließende Alignen/Positionieren - vierter Schritt **S04** - findet dann vor dem Aufsetzen/ Auflegen (fünfter Schritt **S05**) der Substratschicht 2, 2a, 2b auf die Negativform 6, 6a, 6b statt. Das Mikro-Blenden-Array 4, 4a, 4b ist dabei auf die zweite Fläche 21, 21a, 21b der Substratschicht 2, 2a, 2b bereits aufgetragen. In einem sechsten Schritt **S06** des in Figur 5 dargestellten Verfahrens kann das Silikon 5 in der Negativform 6, 6a, 6b, im Wesentlichen wie unter Bezugnahme auf Figur 4 beschrieben, ausgehärtet werden. Anschließend - in Schritt **S07** wird die fertige Projektionseinrichtung 1 aus der Negativform 6, 6a, 6b entformt, wobei das Entformen ebenfalls, wie unter Bezugnahme auf Figur 4 bereits beschrieben, stattfinden kann.

Mithilfe der oben beschriebenen Verfahren kann auch die vorhin beschriebene, in Figur 2 gezeigte Projektionseinrichtung 100 erzeugt werden. Dazu werden drei Substratschichten 2a, 2b, 2c aus einem transparenten, formstabilen Material, beispielsweise aus Glas bereitgestellt. Anschließend wird beispielsweise, wie oben beschrieben, ein erstes Mikrooptik-Array 3a aus transparentem Silikon 5 an der ersten Fläche 20a einer ersten Substratschicht 2a ausgebildet und ein zweites Mikrooptik-Array 3b aus transparentem Silikon 5 an der ersten Fläche 20b einer ersten Substratschicht 2b ausgebildet. Es ist im Prinzip denkbar, dass zum Ausbilden von dem ersten Mikrooptik-Array 3a und von dem zweiten Mikrooptik-Array 3b unterschiedliche transparente Silikone mit beispielsweise verschiedenen Brechungsindizes verwendet werden.

Anschließend kann die erste und die zweite Substratschicht 2a, 2b jeweils mit einem Mikro-Blenden-Array 4a, 4b, ebenfalls wie oben beschrieben, versehen werden (Verfahren der Figuren 4 und 5). Alternativ können die Mikro-Blenden-Arrays 4a, 4b auf die jeweiligen Flächen 20c, 21c einer dritten Substratschicht 2c aufgebracht werden - ein erstes Mikro-Blenden-Array 4a wird auf eine erste Fläche 20c und ein zweites Mikro-Blenden-Array 4b wird auf eine zweite Fläche 21c der dritten Substratschicht 2c aufgebracht.

Die dritte (oder die mittlere) Substratschicht 2c wird zwischen der ersten Substratschicht 2a und der zweiten Substratschicht 2b derart angeordnet, dass die erste Fläche 20a der ersten Substratschicht 2a und die erste Fläche 20b der zweiten Substratschicht 2b der mittleren Substratschicht 2c abgewandt sind (siehe Figuren 2 und 3b).

Weiters werden die Mikro-Blenden-Arrays 4a, 4b und die Mikrooptik-Arrays 3a, 3b derart zueinander positioniert, dass jeder Mikro-Blende 40a, 40b zumindest eine, vorzugsweise genau eine Mikrooptik 30a des ersten Mikrooptik-Arrays 3a und zumindest eine, vorzugsweise genau eine Mikrooptik 30b des zweiten Mikrooptik-Arrays 3b zugeordnet ist. Auf diese Weise wird ebenfalls ein Mikro-Optiksystem gebildet. Anschließend können alle drei Substratschichten 2a, 2b, 2c verbunden, vorzugsweise verklebt werden, um eine Projektionseinrichtung 100 der Figur 2 zu bilden.

Um das Haften des Mikrooptik-Arrays 3a, 3b zu verbessern, kann die erste Fläche 20, 20a, 20b der Substratschicht 2, 2a, 2b vor dem Aufsetzten/Auflegen der Substratschicht 2, 2a, 2b auf die Negativform 6, 6a, 6b vorbehandelt werden. Dabei kann die Vorbehandlung durch Reinigen der ersten Fläche 20, 20a, 20b und durch eine anschließende Oberflächenvorbehandlung der ersten Fläche 20, 20a, 20b mittels Flammensilikatisierung erfolgen.

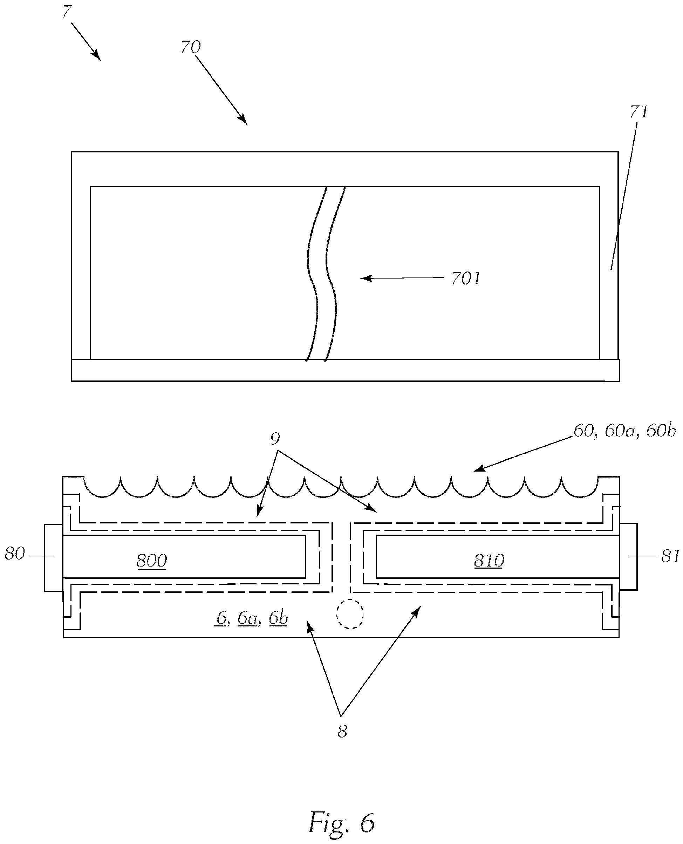

Nun soll unter Bezugnahme auf Figur 6 eine Herstellungseinrichtung **7** umrissen werden, die einem System entspricht, mit dessen Hilfe eine erfindungsgemäße Projektionseinrichtung, beispielsweise die Projektionseinrichtung 1 oder 100 hergestellt werden kann.

Die Herstellungseinrichtung 7 umfasst die vorgenannte Negativform 6, 6a, 6b mit einer dem auszubildenden Mikrooptik-Array 3, 3a, 3b entsprechende formgebende Oberfläche 60, 60a, 60b aufweist. Darüber hinaus weist die Herstellungseinrichtung ein Haltemittel **70,** das vorzugsweise mit einem Vakuumsauger **701** ausgestattet ist, das eingerichtet ist, die Substratschicht (hier nicht gezeigt) mit der Fläche der Negativform 6, 6a, 6b zugewandt zu halten.

Darüber hinaus umfasst die Herstellungseinrichtung 7 ein Positioniermittel, vorzugsweise einen Linearsteller 71. Der Linearsteller 71 sorgt für ein sauberes Aufzusetzen/ Auflegen (ohne Verkippen). Das Positioniermittel 71 ist eingerichtet, die Substratschicht oberhalb der Negativform 6, 6a, 6b zu positionieren und die Substratschicht auf die Negativform 6, 6a, 6b aufzusetzen/ aufzulegen und, im Zuge des Entformens, von der Negativform 6, 6a, 6b abzunehmen. Falls ein Mikro-Blenden-Array 4, 4a, 4b bereits auf der Substratschicht aufgebracht ist, erfolgt das Positionieren der Substratschicht oberhalb der Negativform 6, 6a, 6b erfolgt, wie oben beschrieben, derart, dass jeder Mikro-Blende 40, 40a, 40b zumindest eine Mikrooptik 30, 30a, 30b zugeordnet ist. Darüber hinaus ist es zweckmäßig die Substratschicht derart zu positionieren, dass sie die formgebende Oberfläche 60, 60a, 60b der Negativform 6, 6a, 6b beim Aufsetzen/ Auflegen vollständig bedecken kann.

Ferner kann die Herstellungseinrichtung 7 ein Heizmittel **8** umfassen, das eingerichtet ist, die Negativform 6, 6a, 6b zu erhitzen, und eine Kühlvorrichtung (hier nicht gezeigt) die eingerichtet ist, die Negativform 6, 6a, 6b zu kühlen.

Das Heizmittel 8 kann eine oder mehrere Heizpatronen **80, 81** umfassen, die an oder in der Negativform 6, 6a, 6b, vorzugsweise nah an der formgebenden Oberfläche 60, 60a, 60b der Negativform 6, 6a, 6b, angeordnet sind, das heißt so, dass sie ihre Wärme direkt an die formgebende Oberfläche 60, 60a, 60b ohne wesentliche Wärmeverluste abgeben können. Die Negativform 6, 6a, 6b kann Ausnehmungen **800, 810** zum Aufnehmen der Heizpatronen 80, 81 aufweisen. Figur 6 lässt erkennen, dass die Heizpatronen 80, 81 in den Ausnehmungen 800, 810 aufgenommen sind, sodass sie nah an der formgebenden Oberfläche 60, 60a, 60b sind und in Betrieb ihre Wärme direkt an die formgebende Oberfläche 60, 60a, 60b abgeben können. Das Heizmittel 8 kann eingerichtet sein, die Negativform 6, 6a, 6b auf eine vorbestimmte erste Temperatur zu erwärmen, wobei die erste Temperatur beispielsweise in einem Bereich zwischen etwa 90° C und etwa 200° C, vorzugsweise zwischen etwa 100° C und etwa 150° C, insbesondere zwischen etwa 100° C und etwa 120° C oder etwa 120° C und etwa 150° C liegt.

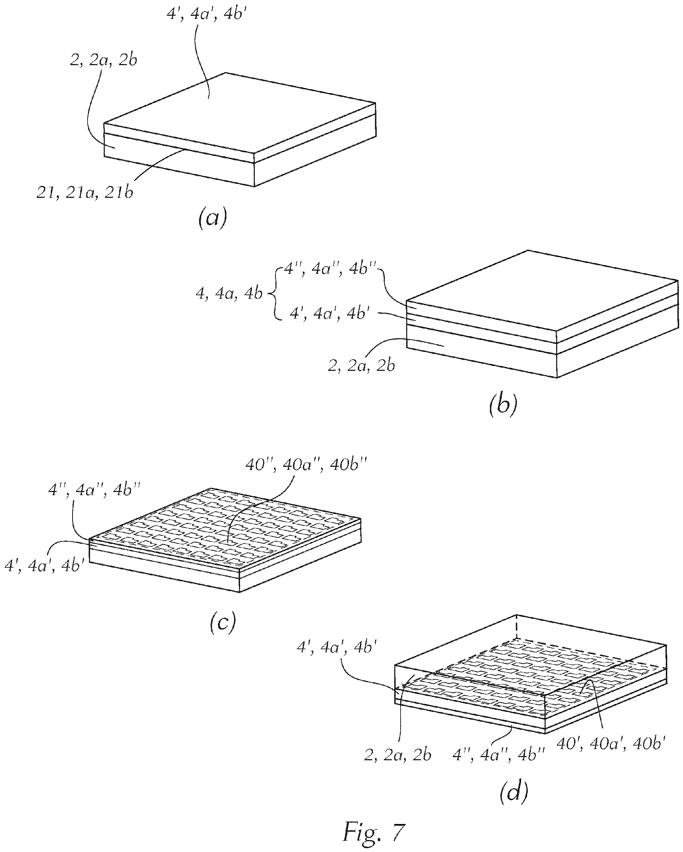

Darüber hinaus kann die Herstellungseinrichtung 7 eine Kühlvorrichtung 9 aufweisen. Die Kühlvorrichtung 9 ist eingerichtet, die auf die vorbestimmte erste Temperatur erwärmte Negativform 6, 6a, 6b auf eine vorbestimmte zweite Temperatur zu kühlen, wobei die zweite Temperatur beispielsweise in einem Bereich zwischen etwa 40° C und etwa 70° C, vorzugsweise zwischen etwa 50° C und etwa 60° C liegt. Dazu kann beispielsweise Druckluft oder Kühlflüssigkeit als Kühlmittel verwendet werden. Die in der Figur 6 gezeigte Kühlvorrichtung sieht vor, dass in der Negativform 6, 6a, 6b Kühlkanäle (mit gestrichelten Linien gezeigt) ausgebildet sind, durch die ein Kühlmittel, beispielsweise eine Kühlflüssigkeit, durchgeführt werden kann. Die Kühlvorrichtung kann auch andere Elemente, wie Zuführmittel, zum Zuführen des Kühlmittels zu der Negativform, aufweisen. Figuren 7a bis 7d zeigen ein Beispiel eines vorgenannten lithographischen Druckverfahrens, welches zum Aufbringen von Mikro-Blenden-Arrays auf lichtdurchlässige Substratschichten verwendet werden kann. Figur 7a zeigt eine transparente Substratschicht 2, 2a, 2b, die zum Aufbringen eines zwei Teilschichten umfassenden Mikro-Blenden-Arrays 4, 4a, 4b herangezogen und wie folgt bearbeitet wird: Gemäß Figur 7a wird die zweite Fläche 21, 21a, 21b der Substratschicht 2, 2a, 2b mit einer reflektierenden metallischen ersten Teilschicht **4', 4a', 4b'** beschichtet.

Anschließend erfolgt ein vollflächiges Bedecken der ersten Teilschicht 4', 4a', 4b' mit einer aus schwarzem lichtabsorbierendem Fotolack bestehenden zweiten Teilschicht **4", 4a", 4b"** (Figur 7b). Als nächster Schritt folgt ein Belichten und Entwickeln der zweiten Teilschicht 4", 4a", 4b" zur Ausbildung von lichtdurchlässigen Fenstern **40", 40a", 40b"** innerhalb der zweiten Teilschicht 4", 4a", 4b" (Figur 7c), durch die korrespondierende Bereiche der ersten Teilschicht 4", 4a", 4b" freigelegt werden. Danach werden lichtdurchlässige Fenster **40', 40a', 40b'** in der ersten Teilschicht 4', 4a', 4b' durch Entfernen der entsprechenden Bereiche der reflektierenden metallischen ersten Teilschicht 4', 4a', 4b' mittels eines Ätzverfahrens ausgebildet (siehe Figur 7d). Die einander korrespondierenden lichtdurchlässigen Fenster 40', 40a', 40b' in der ersten Teilschicht 4', 4a', 4b' und die lichtdurchlässigen Fenstern 40", 40a", 40b" innerhalb der zweiten Teilschicht 4", 4a", 4b" bilden lichtdurchlässige Fenster der Mikro-Blenden 40, 40a, 40b. Die Umrisskonturen dieser lichtdurchlässigen Fenster können beliebig ausgestaltet sein und bilden optisch wirksame Kanten der Mikro-Blenden 40, 40a, 40b; die beispielhaft gezeigte Ausführungsform entspricht einer Abblendlichtverteilung mit einem Asymmetrieanstieg.

Es versteht sich, dass das Aufbringen der Mikro-Blenden-Arrays auf Substratschichten nicht auf das obige Beispiel beschränkt ist. Mikro-Blenden-Arrays können auch aus einer beispielsweise metallischen lichtundurchlässigen Schicht bestehen, die eine Mehrzahl von Durchbrüchen aufweist, wobei die Umrisskonturen der Durchbrüche optisch wirksame Kanten der einzelnen Mikro-Blenden bilden (siehe z.B. WO 2017066817 A1 und WO 2017066818 A1). Ein solches Mikro-Blenden-Array kann auf eine Substratschicht beispielsweise mittels Verklebens aufgebracht werden.

Die vorstehende Diskussion der Erfindung wurde zu Zwecken der Darstellung und Beschreibung vorgestellt. Das Vorstehende soll die Erfindung nicht auf die hierin offenbarte Form oder Formen beschränken. In der vorstehenden ausführlichen Beschreibung sind beispielsweise verschiedene Merkmale der Erfindung in einer oder mehreren Ausführungsformen zum Zwecke der Straffung der Offenbarung zusammengefasst. Diese Art der Offenbarung ist nicht so zu verstehen, dass sie die Absicht widerspiegelt, dass die beanspruchte Erfindung mehr Merkmale erfordert, als in jedem Anspruch ausdrücklich erwähnt wird. Vielmehr liegen, wie die folgenden Ansprüche widerspiegeln, erfinderische Aspekte in weniger als allen Merkmalen einer einzigen vorstehend beschriebenen Ausführungsform vor.

Darüber hinaus liegen, obwohl die Beschreibung der Erfindung die Beschreibung einer oder mehrerer Ausführungsformen und bestimmter Variationen und Modifikationen enthält, andere Variationen und Modifikationen innerhalb des Umfangs der Erfindung, z. B. innerhalb der Fähigkeiten und Kenntnisse von Fachleuten, nach dem Verständnis der vorliegenden Offenbarung.

## Patentansprüche

1. Projektionseinrichtung (1, 100) für ein Kraftfahrzeugscheinwerferlichtmodul, welche Projektionseinrichtung (1, 100) umfasst:
- zumindest eine Substratschicht (2, 2a, 2b, 2c);
- zumindest ein aus einer Mehrzahl von Mikrooptiken (30, 30a, 30b) bestehendes Mikrooptik-Array (3, 3a, 3b), und
- zumindest ein aus einer Mehrzahl von Mikro-Blenden (40, 40a, 40b) bestehendes Mikro-Blenden-Array (4, 4a, 4b), wobei
das zumindest eine Mikrooptik-Array (3, 3a, 3b) an einer ersten Fläche (20, 20a, 20b, 20c) der zumindest einen Substratschicht (2, 2a, 2b, 2c) ausgebildet ist und an der ersten Fläche (20, 20a, 20b) der zumindest einen Substratschicht (2, 2a, 2b, 2c) haftet;
das zumindest eine Mikro-Blenden-Array (4, 4a, 4b) an einer zweiten Fläche (21, 21a, 21b, 21c) der zumindest einen Substratschicht (2, 2a, 2b, 2c) derart angeordnet ist, dass jeder Mikro-Blende (40, 40a, 40b) zumindest eine Mikrooptik (30, 30a, 30b) zugeordnet ist, **dadurch gekennzeichnet, dass**
das Mikrooptik-Array (3, 3a, 3b) aus einem transparenten Silikon (5) ist und die zumindest eine Substratschicht (2, 2a, 2b, 2c) transparent ist und formstabiler als das transparente Silikon (5) ist.

2. Projektionseinrichtung nach Anspruch 1, **dadurch gekennzeichnet, dass** das zumindest eine Mikrooptik-Array (3, 3a, 3b) mittels eines thermischen Abformverfahrens ausgebildet und zum Haften an der ersten Fläche (20, 20a, 20b, 20c) der Substratschicht (2, 2a, 2b, 2c) gebracht ist und/oder das zumindest eine Mikro-Blenden-Array (4, 4a, 4b) an der zweiten Fläche (21, 21a, 21b, 21c) der zumindest einen Substratschicht (2, 2a, 2b, 2c) aufgebracht und versiegelt ist.

3. Projektionseinrichtung nach Anspruch 1 oder 2, **dadurch gekennzeichnet, dass** die zumindest eine Substratschicht (2, 2a, 2b, 2c) aus Glas ist, welches vorzugsweise eine Dicke von etwa 0,5 mm bis etwa 4 mm, vorzugsweise von etwa 1,1 mm aufweist.

4. Projektionseinrichtung nach einem der Ansprüche 1 bis 3, **dadurch gekennzeichnet, dass** das transparente Silikon (5) eine Shore-A-Härte von etwa 30 bis etwa 100, insbesondere von etwa 40 bis etwa 90 aufweist, vorzugsweise transparentes Zwei-Komponenten-Silikon ist.

5. Projektionseinrichtung nach einem der Ansprüche 1 bis 4, **dadurch gekennzeichnet, dass** die Mikro-Blenden (40, 40a, 40b) derart ausgebildet sind und das Mikro-Blenden-Array (4, 4a, 4b) in der Projektionseinrichtung (1) derart angeordnet ist, dass die Projektionseinrichtung (1) zum Bilden einer Abblendlichtverteilung und/oder einer Teilfernlichtverteilung oder einer Fernlichtverteilung eingerichtet ist.

6. Projektionseinrichtung nach einem der Ansprüche 1 bis 5, **dadurch gekennzeichnet, dass** die Mikrooptiken (30, 30a, 30b) des zumindest einen Mikrooptik-Arrays (3, 3a, 3b) gleiche Höhe, beispielsweise in einem Bereich zwischen etwa 0,01 mm und etwa 2 mm, vorzugsweise zwischen etwa 0,1 mm und etwa 1,5 mm, insbesondere eine Höhe von etwa 1,1 mm aufweisen.

7. Projektionseinrichtung nach einem der Ansprüche 1 bis 6, **gekennzeichnet durch** drei Substratschichten (2a, 2b, 2c) und zwei Mikrooptik-Arrays (3a, 3b), wobei eine mittlere Substratschicht (2c) zwischen einer ersten Substratschicht (2a) und einer zweiten Substratschicht (2b) angeordnet ist, wobei eine erste Fläche (20a) der ersten Substratschicht (2a), an der ein erstes Mikrooptik-Array (3a) ausgebildet ist und haftet, und eine erste Fläche (20b) der zweiten Substratschicht (2b), an der ein zweites Mikrooptik-Array (3b) ausgebildet ist und haftet, der mittleren Substratschicht (2c) abgewandt sind, wobei das zumindest eine Mikro-Blenden-Array (4, 4a, 4b) an einer zweiten Fläche (21a, 21b) der ersten oder der zweiten Substratschicht (2a, 2b) oder an einer der zwei Flächen (20c, 21c) der mittleren Substratschicht (2c) angeordnet ist.

8. Projektionseinrichtung nach Anspruch 7, **dadurch gekennzeichnet, dass** zumindest zwei Mikro-Blenden-Arrays (4a, 4b) vorgesehen sind, wobei vorzugsweise ein erstes Mikro-Blenden-Array (4a) zum Formen einer Abblendlichtverteilung und/oder einer Teilfernlichtverteilung oder einer Fernlichtverteilung ausgebildet ist und ein zweites Mikro-Blenden-Array (4b) zum Korrigieren von Abbildungsfehlern vorgesehen ist.

9. Projektionseinrichtung nach Anspruch 7 oder 8, **dadurch gekennzeichnet, dass** die drei Substratschichten (2a, 2b, 2c) miteinander verbunden, vorzugsweise verklebt sind.

10. Kraftfahrzeugscheinwerferlichtmodul (1000, 1001) beziehungsweise Kraftfahrzeugscheinwerfer umfassend zumindest eine Projektionseinrichtung (1, 100) nach einem der Ansprüche 1 bis 9, und zumindest eine Lichtquelle (2000), vorzugsweise eine halbleiterbasierte Lichtquelle, insbesondere eine LED-Lichtquelle, wobei die zumindest eine Projektionseinrichtung (1, 100) der zumindest einen Lichtquelle (2000) in Abstrahlrichtung derart nachgelagert ist, dass die zumindest eine Lichtquelle (2000) im Wesentlichen ihr gesamtes Licht in die zumindest eine Projektionseinrichtung (1, 100) einstrahlt und die zumindest eine Projektionseinrichtung (1, 100) das in sie eingestrahlte Licht in einen Bereich vor das Kraftfahrzeugscheinwerferlichtmodul (1000, 1001) beziehungsweise vor den Kraftfahrzeugscheinwerfer in Form einer Abblendlichtverteilung und/oder einer Teilfernlichtverteilung oder einer Fernlichtverteilung projiziert.

11. Verfahren zum Herstellen einer Projektionseinrichtung (1, 100), insbesondere einer Projektionseinrichtung (1, 100) nach einem der Ansprüche 1 bis 9 umfassend folgende Schritte:
- Bereitstellen von
* transparentem Silikon (5);
* zumindest einer Substratschicht (2, 2a, 2b) aus einem transparenten, formstabilen Material, beispielsweise aus Glas, wobei die Substratschicht (2, 2a, 2b) formstabiler als das transparente Silikon (5) ist, und
* zumindest einem aus einer Mehrzahl von Mikro-Blenden (40, 40a, 40b) bestehenden Mikro-Blenden-Arrays (4, 4a, 4b);
- Ausbilden zumindest eines aus einer Mehrzahl von Mikrooptiken (30, 30a, 30b) bestehenden Mikrooptik-Arrays (3, 3a, 3b) aus dem transparenten Silikon (5) an einer ersten Fläche (20, 20a, 20b) der zumindest einen Substratschicht (2, 2a, 2b) und
- Anordnen des zumindest einen Mikro-Blenden-Arrays (4, 4a, 4b) an einer zweiten Fläche (21, 21a, 21b) der zumindest einen Substratschicht (2, 2a, 2b), wobei das zumindest eine Mikrooptik-Array (3, 3a, 3b) und das zumindest eine Mikro-Blenden-Array (4, 4a, 4b) derart zueinander angeordnet sind, dass jeder Mikro-Blende (40, 40a, 40b) zumindest eine Mikrooptik (30, 30a, 30b) zugeordnet ist, und das transparente Silikon (5) vorzugsweise eine Shore-A-Härte von etwa 30 bis etwa 100, insbesondere von etwa 40 bis etwa 90 aufweist, insbesondere ein Zwei-Komponenten-Silikon ist.

12. Verfahren nach Anspruch 11, **dadurch gekennzeichnet, dass** das Ausbilden zumindest eines aus einer Mehrzahl von Mikrooptiken (30, 30a, 30b) bestehenden Mikrooptik-Arrays (3, 3a, 3b) aus dem transparenten Silikon (5) an einer ersten Fläche (20, 20a, 20b) der zumindest einen Substratschicht (2, 2a, 2b) folgende Teilschritte umfasst:
- Bereitstellen zumindest einer Negativform (6, 6a, 6b) mit einer formgebenden Oberfläche (60, 60a, 60b), die dem zumindest einen Mikrooptik-Array (3, 3a, 3b) entspricht;
- Gießen des transpatenten Silikons (5) in die zumindest eine Negativform (6, 6a, 6b);
- Aufsetzten/Auflegen der zumindest einen Substratschicht (2, 2a, 2b) auf die zumindest eine Negativform (6, 6a, 6b);
- Aushärten des Silikons (5) in der zumindest einen Negativform (6, 6a, 6b), und
- Entformen des Mikrooptik-Arrays (3, 3a, 3b) aus der zumindest einen Negativform (6, 6a, 6b).

13. Verfahren nach Anspruch 12, **dadurch gekennzeichnet, dass** während des Aushärtens des Silikons (5) der zumindest einen Negativform (6, 6a, 6b), insbesondere der formgebenden Oberfläche (60, 60a, 60b), Wärme zugeführt wird und vor dem Entformen die zumindest eine Negativform (6, 6a, 6b) gekühlt wird.

14. Verfahren nach Anspruch 13, **dadurch gekennzeichnet, dass** die zumindest eine Negativform (6, 6a, 6b) während des Aushärtens des Silikons (5) auf eine vorbestimmte erste Temperatur erhitzt wird, wobei die erste Temperatur beispielsweise in einem Bereich zwischen etwa 90° C und etwa 200° C, vorzugsweise zwischen etwa 100° C und etwa 150° C, insbesondere zwischen etwa 100° C und etwa 120° C oder etwa 120° C und etwa 150° C liegt, und bei der vorbestimmten ersten Temperatur für eine vorzugsweise von der vorbestimmten ersten Temperatur abhängige Dauer gehalten wird, wobei die Dauer beispielsweise zwischen etwa 0,5 Minuten und 6 Minuten, vorzugsweise zwischen 1 Minute und 5 Minuten beträgt.

15. Verfahren nach Anspruch 13 oder 14, **dadurch gekennzeichnet, dass** die zumindest eine Negativform (6, 6a, 6b) auf eine vorbestimmte zweite Temperatur gekühlt wird, wobei die zweite Temperatur beispielsweise in einem Bereich zwischen etwa 40° C und etwa 70° C, vorzugsweise zwischen etwa 50° C und etwa 60° C liegt.

16. Verfahren nach Anspruch 15, **dadurch gekennzeichnet, dass** die zumindest eine Negativform (6, 6a, 6b) mittels Druckluft und/oder Kühlflüssigkeit gekühlt wird.

17. Verfahren nach einem der Ansprüche 11 bis 16, **dadurch gekennzeichnet, dass** die erste Fläche (20, 20a, 20b) der zumindest einen Substratschicht (2, 2a, 2b) vor dem Aufsetzten/ Auflegen der zumindest einen Substratschicht (2, 2a, 2b) auf die zumindest eine Negativform (6, 6a, 6b) vorbehandelt wird.

18. Verfahren nach Anspruch 17, **dadurch gekennzeichnet, dass** die Vorbehandlung folgende Teilschritte umfasst:
- Reinigen zumindest der ersten Fläche (20, 20a, 20b);
- Oberflächenvorbehandlung der ersten Fläche (20, 20a, 20b) durch Flammensilikatisierung.

19. Verfahren nach einem der Ansprüche 11 bis 18, **dadurch gekennzeichnet, dass** das Anordnen des zumindest einen Mikro-Blenden-Arrays (4, 4a, 4b) an einer zweiten Fläche (21, 21a, 21b) der zumindest einen Substratschicht (2, 2a, 2b) folgende Teilschritte umfasst:
- Aufbringen, beispielsweise durch Aufdrucken, des zumindest einen Mikro-Blenden-Arrays (4, 4a, 4b) auf die zweite Fläche (21, 21a, 21b) der zumindest einen Substratschicht (2, 2a, 2b);
- Positionieren des zumindest einen Mikro-Blenden-Array (4, 4a, 4b) hinsichtlich des zumindest einen Mikrooptik-Arrays (3, 3a, 3b) derart, dass jeder Mikro-Blende (40, 40a, 40b) zumindest eine Mikrooptik (30, 30a, 30b) zugeordnet ist.

20. Verfahren nach einem der Ansprüche 11 bis 19, **dadurch gekennzeichnet, dass**
- zumindest drei Substratschichten (2a, 2b, 2c) aus einem transparenten, formstabilen Material, beispielsweise aus Glas bereitgestellt werden, wobei eine mittlere Substratschicht (2c) zwischen einer ersten Substratschicht (2a) und einer zweiten Substratschicht (2b) derart angeordnet wird, dass eine erste Fläche (20a) der ersten Substratschicht (2a) und eine erste Fläche (20b) der zweiten Substratschicht (2b) der mittleren Substratschicht (2c) abgewandt sind,
- ein erstes aus einer Mehrzahl von Mikrooptiken (30a) bestehendes Mikrooptik-Array (3a) aus transparentem Silikon (5) an der ersten Fläche (20a) der ersten Substratschicht (2a) ausgebildet wird,
- ein zweites aus einer Mehrzahl von Mikrooptiken (30b) bestehendes Mikrooptik-Array (3b) aus transparentem Silikon (5) an der ersten Fläche (20b) der zweiten Substratschicht (2b) ausgebildet wird,
- das zumindest eine Mikro-Blenden-Array (4, 4a, 4b) an einer zweiten Fläche (21a) der ersten Substratschicht (2a) oder an einer zweiten Fläche (21b) der zweiten Substratschicht (2b) oder an einer der zwei Flächen (20c, 21c) der mittleren Substratschicht (2c) derart angeordnet wird, dass jeder Mikro-Blende (40, 40a, 40b) zumindest eine, vorzugsweise genau eine Mikrooptik (30a) des ersten Mikrooptik-Arrays (3a) und zumindest eine, vorzugsweise genau eine Mikrooptik (30b) des zweiten Mikrooptik-Arrays (3b) zugeordnet ist.

21. Verfahren nach Anspruch 20, **dadurch gekennzeichnet, dass** die drei Substratschichten (2a, 2b, 2c) verbunden, vorzugsweise verklebt werden.
